# EUROPEAN PATENT SPECIFICATION

(11) **EP 2 655 698 B1**
(45) Date of publication and mention of the grant of the patent: **15.05.2019**
(21) Application number: 10793274.1
(22) Date of filing: 23.12.2010
(51) Int. Cl.: C25D 7/12, H05K 3/20

(54) **MASTER ELECTRODE FOR ECPR AND MANUFACTURING METHODS THEREOF**
MASTERELEKTRODE FÜR ECPR UND HERSTELLUNGSVERFAHREN DAFÜR
ÉLECTRODE MAÎTRE POUR ECPR ET SES PROCÉDÉS DE FABRICATION

(43) Date of publication of application: 30.10.2013
(73) Proprietor: Luxembourg Institute of Science and Technology, 4362 Esch-sur-Alzette (LU)
(72) Inventor: MÖLLER, Patrik, S-112 52 Stockholm (SE); FREDENBERG, Mikael, S-112 34 Stockholm (SE); DAINESE, Matteo, F-38000 Grenoble (FR); CORLEVI, Silvia, S-181 56 Lidingö (SE); ARONSSON, Cecilia, S-174 47 Sundbyberg (SE); VAN DEN HOEK, Wilbert, Saratoga CA 95070 (US); CUTHBERTSON, Alan, F-38320 Herbeys (FR)
(74) Representative: Lecomte & Partners
(86) International application number: PCT/EP2010/070644
(87) International publication number: WO 2012/084045

(56) References cited:
- WO-A1-02/103085
- JP-A- 57 154 829
- US-A1- 2003 230 808
- US-A1- 2009 229 855
- JOHNSON R W ET AL: "THERMA CYCLE RELIABILIUTY OF SOLDER JOINTS TO ALTERNATE PLATING FINISHES", CIRCUIT WORLD, XX, XX, 1 February 1999 (1999-02-01), pages 27-30, XP000937743, ISSN: 0305-6120
- VIJH A K ET AL: "Electrochemical activity of silicides of some transition metals for the hydrogen evolution reaction in acidic solutions", INTERNATIONAL JOURNAL OF HYDROGEN ENERGY, ELSEVIER SCIENCE PUBLISHERS B.V., BARKING, GB, vol. 15, no. 11, 1 January 1990 (1990-01-01), pages 789-794, XP025639687, ISSN: 0360-3199, DOI: 10.1016/0360-3199(90)90014-P [retrieved on 1990-01-01]
- DATABASE INSPEC [Online] THE INSTITUTION OF ELECTRICAL ENGINEERS, STEVENAGE, GB; 28 February 1982 (1982-02-28), MURARKA S P ET AL: "Resistivities of thin film transition metal silicides", Database accession no. 1897801 & JOURNAL OF THE ELECTROCHEMICAL SOCIETY USA, vol. 129, no. 2, 1 January 1990 (1990-01-01), - 1 January 1990 (1990-01-01), pages 293-301, ISSN: 0013-4651
- S. P. Murarka: "Resistivities of Thin Film Transition Metal Silicides", Journal of The Electrochemical Society, vol. 129, no. 2, 1 January 1982 (1982-01-01), page 293, XP055512458, ISSN: 0013-4651, DOI: 10.1149/1.2123815

## Description

### Field of the Invention

This invention pertains in general to the field of electrochemical pattern replication. More particularly the invention relates to a master electrode for electrochemical pattern replication, and manufacturing methods thereof.

### Background of the Invention

Electroplating/electroetching is used for microelectronics in a wide range of applications, such as interconnects, components, waveguides, inductors, contact pads etc.

In the field of microelectronics electroplating/electroetching is suitable for applications involving production of micro and nano structures in single or multiple layers, fabrication of PWB (printed wiring boards), PCB (printed circuit boards), MEMS (micro electro mechanical systems), IC (integrated circuit) interconnects, above IC interconnects, sensors, flat panel displays, magnetic and optical storage devices, solar cells and other electronic devices. It can so be used for different types of structures in conductive polymers, structures in semiconductors, structures in metals, and others. Even 3D-structures in silicon, such as by formation of porous silicon, are possible.

Chemical vapor deposition and physical vapor deposition are processes that may also be used for metallization, but electroplating/electroetching is often preferred since it is generally less expensive than other metallization processes and it can take place at ambient temperatures and at ambient pressures.

Electroplating/electroetching of a work piece takes place in a reactor containing an electrolyte. An anode, carrying the metal to be plated, is connected to a positive voltage. In some cases, the anode is inert and the metal to be plated comes from the ions in the electrolyte. The conductivity of the work piece, such as a semiconductor substrate, is generally too low to allow the structures to be plated to be connected through the substrate to backside contacts. Therefore, the structures to be plated first have to be provided with a conductive layer, such as a seed layer. Leads connect the pattern to finger contacts on the front side. The finger contacts are in turn connected to a negative voltage. The electroplating step is an electrolytic process where the metal is transferred from the anode, or from the ions in the electrolyte, to the conductive pattern (cathode) by the electrolyte and the applied electric field between the anode and the conductive layer on the work piece, which forms the cathode.

The ever-increasing demand for smaller, faster and less expensive microelectronic and micro-electromechanical systems requires corresponding development of efficient and suitable manufacturing techniques, which has resulted in the development of electrochemical pattern replication (ECPR).

In ECPR plating/etching cells or cavities are formed between a master electrode and the substrate, said cavities being defined by a conductive surface or electrode layer in the bottom of the cavities on the master, an insulating material on the surface of the master, defining the pattern to be plated/etched, and the conductive bulk material of the substrate. During plating, a pre-deposited anode material has been arranged, in the cavities. The master electrode and the substrate are put in close contact with each other in the presence of an electrolyte, suitable for the intended purpose, such that the electrolyte is "trapped" in the ECPR plating/etching cavities. WO 02/103085, to the present inventors, describes a system of this kind.

After ECPR plating some or all of the cavities may have residual material remaining depending on the initial thickness of the pre-deposited material and the amount transferred during the ECPR process. Before the master electrode can be re-used it may be necessary to chemically remove the residual material in the cavities. The electrode layer must therefore be inert to such chemicals. In the case of the master being re-used many tens or hundreds of time, then the electrode layer much provide a high degree of resistance to such chemicals. The electrode layer material must also be able to survive the ECPR process during tens or hundreds of cycles.

In metallurgy system the Ni-Pd-Au system is well known and has been used in the packaging world. In this case the Pd acts a diffusion barrier to prevent diffusion of Ni into Au. It has been noted that Ni alone is not possible in the master since this is readily etched by chemicals used in ECPR.

An example of electrode is given in document US 2009/229855 A1.

### Summary of the Invention

Accordingly, the present invention preferably seeks to mitigate, alleviate or eliminate one or more of the above-identified deficiencies in the art and disadvantages.

For these reasons a master electrode and a manufacturing method thereof is provided in accordance with claims 1 and 7.

Further advantageous embodiments will be apparent from the appended dependent claims.

### Brief Description of the Drawings

These and other aspects, features and advantages of which the invention is capable of will be apparent and elucidated from the following description of embodiments of the present invention, reference being made to the accompanying drawings, in which
Figure 1 illustrates a master electrode with cavities at various manufacturing phases of said master electrode, according to some embodiments of the present invention; and
Figures 2-5 illustrate flow-charts of method steps according to embodiments of the present invention.

### Description of embodiments

The following description focuses on embodiments of the present invention applicable to Electro Chemical Pattern Replication (ECPR). However, it will be appreciated that the invention is not limited to this application but may be applied to many other replication, patterning or bonding processes within the field of micro electronics.

A master electrode may be formed as a disc with a first side or a front side and a second side or a backside. On the front side an active trench pattern with trench depth, such as uniform trench depth, across the disc wafer can be formed. An electrode layer is formed in the bottom of the trenches on the front side.

On the backside an electrode layer can be formed with an edge exclusion. The electrode layer is one example of a layer having a material with a low ohmic contact with a good chemical resistance to a variety of chemistries. For example in the case of copper such chemistries are commonly sulphuric acid (H2SO4), hydrogen peroxide (H202), copper sulfate (CuS04), sodium persulfate (Na2S20s) and/or ammonium persulfate (NH4)2S20 based (aqueous) solutions.

The disc may be comprised of a bulk of doped Si substrate. The disc edges may also comprise a dielectric material.

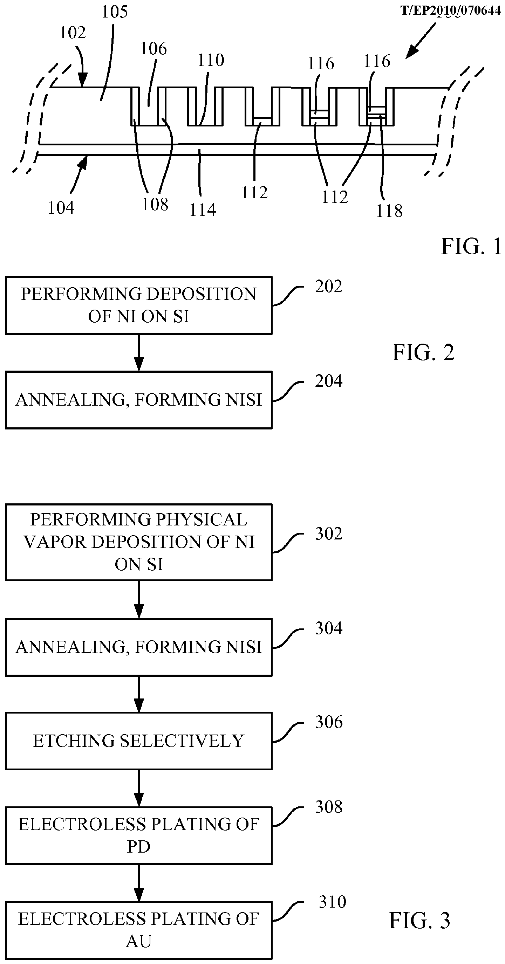

Figure 1 illustrates a master electrode 100 according to some embodiments of the present invention. More precisely figure 1 illustrates a master electrode 100 for forming an electrochemical cell with a substrate, where the master electrode comprises a first side 102 for arrangement on the substrate and a second side 104 for connection to a power supply. The master electrode further comprises at least one cavity 106 on the first side 102 for formation of said electrochemical cell, where said cavity 106 has electrically insulating (vertical) side walls 108 and an electrically conductive bottom 110. The conductive bottom may comprise nickel silicide 112. More generally, the conductive layer may be generally described as NiₓSi_{y} where the values of x and y are modulated by the anneal conditions. Nickel silicide has six thermodynamically stable phases, namely: Ni₃Si, Ni₃₁Si₁₂, Ni₂Si, Ni₃Si₂, NiSi, and NiSi₂. Thus, x can vary from 1 to 31 and Y from 1 to 12.. One example is Ni₂Si. When the nickel silicide is a Ni-rich nickel silicide, such as when x is greater than y, such as Ni₂Si, the deposition of Pd on the nickel silicide is further improved. The master electrode 100 also comprises an electrically conductive surface 114 on the second side 104 for connection to a power supply. The electrically conductive surface 114 is conductively connected to the electrically conductive bottom 110 comprising nickel silicide 112 though the bulk of the disc.

It is advantageous that the bottom of the cavities comprise an alloy of Ni and Si, since the alloy NiₓSi_{y} generally provides a low resistivity and a good thermal stability. The usage of NiₓSi_{y} is herein preferable since it is chemically stable when exposed to chemical agents used for cleaning and Cu etching used in ECPR flows.

According to one embodiment of the present invention, the bottom of the cavities further has a layer of electrically conducting Pd. In addition, onto the electrically conductive Pd the bottom also may comprise electrically conductive Au.

According to an embodiment of the present invention a master electrode for defining an electrochemical cell with a substrate, where the master electrode has nickel silicide, Pd and Au in the bottom of the cavities can be obtained by using the method described below.

The master electrode for defining the electrochemical cell with a substrate having at least one cavity on a first side, wherein the cavity forms an electrochemical cell, comprises obtaining an Ni-comprising electrically conductive bottom of the at least one cavity on the first side of the master electrode, by performing deposition of Ni by Physical Vapor Deposition of Ni onto Si, and annealing the Ni-comprising electrically conductive bottom. During the annealing process nickel silicide is formed in the electrically conductive bottom of the cavities. After the annealing step, unreacted nickel may be selectively etched using an acid based selective etch, leaving the conductive nickel silicide on the frontside in the bottom of the cavities only. The conditions of the annealing process are selected in order to provide an optimal interface and phase between the nickel silicide and the Pd or Au layer.

In comparison with known systems as mentioned above, it is noted that the Ni layer is replaced by a Ni based silicide layer in the bottom of the trenches. The fact that nickel silicide is a self-aligned process when combined with the spacer technology means that the electrode layer is formed only in exposed Si in the bottom of the trenches. The use of other silicides, for instance Pt-silicide may be possible, however, these are not as easy as Ni to integrate in the ECPR process in terms of annealing and etching.

After the annealing and etching, the master electrode is then processed by performing electroless deposition of the adhesive agent Pd in the bottom of the cavities.

The Pd as deposited herein works as an adhesive agent allowing Au to be deposited onto the nickel silicide alloy. When using Pd as adhesive agent, Pd may be selectively deposited on conducting surfaces, since Pd may be deposited with electroless or electrochemical deposition. Thus, Pd may selectively be applied onto the conductive bottom 110, which may comprise nickel silicide 112. Other deposition methods, such as chemical or physical vapor preposition, deposit on all surfaces subjected to the metal to be deposited. Also, Pd has a specifically good adhesion property with regard to nickel silicide, such that Pd is a preferred adhesion agent when the conductive bottom 110 comprises nickel silicide 112, because of this unexpected technical effect during the specific circumstances. Other metals that may be applied with electroless deposition have a poor adhesion property with regard to nickel silicide in comparison with Pd. Also, Pd is very stable during the prevalent circumstances during for example the cleaning and process steps of ECPR. It is for example more stable than Ni.

Having deposited the Pd, electroless, immersion or electrochemical deposition of Au is performed forming an electrically conductive bottom. Applying electroless or immersion Au deposition processes for the capping layer, it has been found empirically that it is difficult to deposit a thin uniform layer of Au on the nickel silicide. With such processes it is observed that the Au film adhesion and morphology is a strong function of the nickel silicide grain structure and phase.. The use of Pd creates an adhesion layer between the Au and the silicide enabling a uniform continuous layer of Au to be deposited. When Au is applied onto the Pd layer at the conductive bottom 110, the Au layer acts as further protective layer, as well as conductive surface in the at least one cavity 106. The combination of Au and Pd then provides a further improved protection to the conductive material below, such as the nickel silicide layer 112, since possible pin-holes in the Au layer is compensated for by the Pd layer, having the good stability referred to above, while simultaneously providing for good adhesion between the nickel silicide and the Au layer. Thus, the Pd layer acts as an adhesion layer for another more noble material such as Ag, Au, or Pt. In the case of an Ay top layer, the Au top layer is acting as a chemical and electrochemical protection layer for the underlying Pd layer, since the noble metal Au is even more stable in the steps of ECPR than Pd. Additionally, the Au layer has a non-oxidizing surface which is beneficial when pre-filling, for instance by electroplating, the master cavities 106 with an anode material, such as copper, that is intended for subsequent transfer during the ECPR process.

The Pd layer can allow for adherence of other materials than Au that can be deposited for instance by electroless, immersion or electrochemical deposition, such as Pt, Ag, even though Au is preferred due to its stable properties in ECPR and good adhesion properties to Pd.

However, according to one embodiment of the present invention, the bottom of the cavities further has a layer of electrically conducting Au. This Au layer is then applied directly onto the nickel silicide 112 at the conductive bottom 110. The electrically conductive Au layer positioned onto the nickel silicide improved chemical and electrochemical stability of the metal stack may be obtained, since the Au and nickel silicide are more chemically and electrochemically stable, i.e. less soluble, than the Pd and hence more durable in the ECPR process and the cleaning steps connected to it. Even if Au is used as a protective layer in combination with Pd, this Au layer can, according to above, have pin-holes and may not protect the Pd in all portions of the electrode layer. Applying Au directly onto the nickel silicide 112 can therefore increase the lifetime of the electrode layer.

Figure 2 presents a flowchart of method steps of a method for forming a master electrode according to one embodiment of the present invention. The method is configured for forming a master electrode 100 for defining an electrochemical cell with a substrate, wherein the master electrode has at least one cavity 106 on a first side 102, wherein the cavity forms an electrochemical cell, said method comprising:
obtaining an Ni-comprising electrically conductive bottom 202, 302, 402, 502 of the at least one cavity 106 on the first side of the master electrode, by performing deposition of Ni onto Si, and
annealing 204, 304, 406, 504 the Ni-comprising electrically conductive bottom, forming an electrically conductive bottom comprising nickel silicide 112.

The method can be executed in various ways on which a few examples will be briefly described below.

Figure 3 presents a flow-chart of method steps according to an alternative embodiment of the present invention The Ni-comprising electrically conductive bottom 202, 302 of the at least one cavity 106 on the first side of the master electrode is performed by performing Physical Vapor Deposition, PVD of Ni on Si, 302, after which annealing 204, 304 the Ni-comprising electrically conductive bottom, forming an electrically conductive bottom comprising nickel silicide 112, is executed. After annealing, selectively etching is performed, 306. Subsequently, electroless plating of Pd onto the electrically conductive bottom 110 comprising nickel silicide, is performed, 308, followed by electroless plating or immersion deposition of Au onto the electrically conductive bottom 110 comprising nickel silicide and deposited Pd by electroless plating, 310.

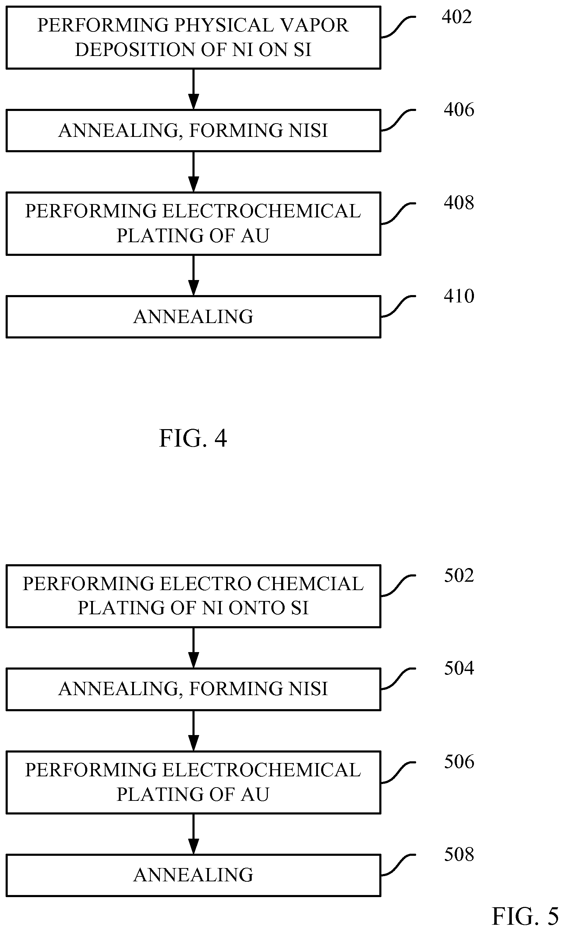

Figure 4 presents a flow-chart of method steps according to another embodiment of the present invention. The Ni-comprising electrically conductive bottom 202, 402 of the at least one cavity 106 on the first side of the master electrode is performed by performing Physical Vapor Deposition, PVD of Ni on Si, 402, i.e. in the way as 302, mentioned above. Then annealing is performed, forming nickel silicide in 406.

Having formed nickel silicide in 406 selective etching may be performed according to variant of the current alternative embodiment of the present invention.

In 408, electrochemical plating of Au onto the electrically conductive bottom 110 comprising nickel silicide is performed, after which annealing is performed in 410.

Yet another embodiment of the present invention is described in connection to figure 5, presenting a flow chart of method steps. In 502, electrochemical plating of Ni onto Si is performed, forming a Ni-comprising electrically conductive bottom 202, 502 of the at least one cavity 106 on the first side of the master electrode 100. Annealing, forming nickel silicide is then performed in 504. Electrochemical plating of Au onto the electrically conductive bottom 110 comprising nickel silicide is then performed in 506. Finally, annealing is performed in 508.

In the claims, the term "comprises/comprising" does not exclude the presence of other elements or steps. Furthermore, although individually listed, a plurality of means, elements or method steps may be implemented by e.g. a single unit or processor. Additionally, although individual features may be included in different claims, these may possibly advantageously be combined, and the inclusion in different claims does not imply that a combination of features is not feasible and/or advantageous. In addition, singular references do not exclude a plurality. The terms "a", "an", "first", "second" etc do not preclude a plurality. Reference signs in the claims are provided merely as a clarifying example and shall not be construed as limiting the scope of the claims in any way.

## Claims

1. A master electrode (100) for forming an electrochemical cell with a substrate, said master electrode comprising a first side (102) for arrangement on the substrate and a second side (104) for connection to a power supply, said master electrode further comprising:
at least one cavity (106) on the first side (102) for formation of said electrochemical cell, said cavity (106) having electrically insulating side walls (108) and an electrically conductive bottom (110) comprising silicide (112);
an electrically conductive surface (114) on the second side (104) for connection to a power supply, said electrically conductive surface (114) being conductively connected to the electrically conductive bottom (110) comprising silicide (112),
**characterized in that** the substrate is a silicon substrate and the silicide is nickel silicide.

2. The master electrode (100) of claim 1, in which said electrically conductive bottom (110) comprises at least one layer of Au (116), wherein nickel silicide (112) is arranged below the at least one layer of Au (116).

3. The master electrode (100) of any of claim 2, in which the electrically conductive bottom (110) further comprises an adhesion layer (118) between the electrically conductive bottom comprising nickel silicide (112) and the at least one layer of Au (116), wherein said adhesion layer (118) is comprised of Pd.

4. The master electrode (100) of any of claims 1-3, wherein the electrically conductive surface (114) on the second side (104) comprises Ni material (114).

5. The master electrode (100) of any of claims 1-4, wherein the nickel silicide is a nickel silicide of the general formula NixSiy, wherein x can vary from 1 to 31 and Y from 1 to 12.

6. The master electrode (100) of claim 5, wherein x is greater than y.

7. A method for forming a master electrode (100) for defining an electrochemical cell with a silicon substrate, wherein the master electrode has at least one cavity (106) on a first side (102), wherein the cavity forms an electrochemical cell, said method comprising:
obtaining an Ni-comprising electrically conductive bottom (202, 302, 402, 502) of the at least one cavity (106) on the first side of the master electrode, by performing deposition of Ni onto the silicon substrate, and
annealing (304, 406, 504) the Ni-comprising electrically conductive bottom, forming an electrically conductive bottom comprising nickel silicide (112).

8. The method of claim 7, wherein deposition of Ni comprises Physical Vapor Deposition, PVD (302, 402), of Ni.

9. The method of claim 7 or 8, wherein deposition of Ni further comprises Electro Chemical Plating, ECP (502) of Ni.

10. The method of claim 7-9, further comprising Electro Chemical Plating, ECP (408, 506) of a Au layer onto the electrically conductive bottom (110) comprising nickel silicide (112).

11. The method according to claim 7 or 8, further comprising performing an electroless deposition (step 308) of Pd (118) onto the electrically conducting bottom (110) comprising nickel silicide (112).

12. The method of claim 11, further comprising performing electroless or immersion deposition (310) of Au (116) onto the electrically conductive bottom (110) comprising nickel silicide (112) and deposited Pd (118).

## Patentansprüche

1. Masterelektrode (100) zur Bildung einer elektrochemischen Zelle mit einem Substrat, wobei die Masterelektrode eine erste Seite (102) zur Anordnung auf dem Substrat und eine zweite Seite (104) zur Verbindung mit einer Stromversorgung umfasst, wobei die Masterelektrode weiter umfasst:
mindestens eine Vertiefung (106) an der ersten Seite (102) zur Bildung der elektrochemischen Zelle, wobei die Vertiefung (106) elektrisch isolierende Seitenwände (108) und einen elektrisch leitenden Boden (110), der Silizid (112) umfasst, aufweist;
eine elektrisch leitende Oberfläche (114) an der zweiten Seite (104) zur Verbindung mit einer Stromversorgung, wobei die elektrisch leitende Oberfläche (114) leitend mit dem elektrisch leitenden Boden (110), der Silizid (112) umfasst, verbunden ist,
**dadurch gekennzeichnet, dass** das Substrat ein Siliziumsubstrat ist und das Silizid Nickelsilizid ist.

2. Masterelektrode (100) nach Anspruch 1, wobei der elektrisch leitende Boden (110) mindestens eine Goldschicht (116) umfasst, wobei Nickelsilizid (112) unter der mindestens einen Goldschicht (116) angeordnet ist.

3. Masterelektrode (100) nach einem von Anspruch 2, wobei der elektrisch leitende Boden (110) weiter eine Haftschicht (118) zwischen dem elektrisch leitenden Boden, der Nickelsilizid (112) umfasst, und der mindestens einen Goldschicht (116) umfasst, wobei die Haftschicht (118) aus Pd besteht.

4. Masterelektrode (100) nach einem der Ansprüche 1-3, wobei die elektrisch leitende Oberfläche (114) an der zweiten Seite (104) Ni-Material (114) umfasst.

5. Masterelektrode (100) nach einem der Ansprüche 1-4, wobei das Nickelsilizid ein Nickelsilizid der allgemeinen Formel NixSiy ist, wobei x von 1 bis 31 und Y von 1 bis 12 variieren kann.

6. Masterelektrode (100) nach Anspruch 5, wobei x größer als y ist.

7. Verfahren zur Bildung einer Masterelektrode (100) zum Definieren einer elektrochemischen Zelle mit einem Siliziumsubstrat, wobei die Masterelektrode mindestens eine Vertiefung (106) an einer ersten Seite (102) aufweist, wobei die Vertiefung eine elektrochemische Zelle bildet, wobei das Verfahren umfasst:
Erhalten eines Ni-umfassenden elektrisch leitenden Bodens (202, 302, 402, 502) der mindestens einen Vertiefung (106) an der ersten Seite der Masterelektrode durch Durchführung von Abscheidung von Ni auf das Siliziumsubstrat, und
Glühen (304, 406, 504) des Ni-enthaltenden elektrisch leitenden Bodens, wodurch ein elektrisch leitender Boden, der Nickelsilizid (112) umfasst, gebildet wird.

8. Verfahren nach Anspruch 7, wobei die Abscheidung von Ni physikalische Dampfabscheidung, PVD, (302, 402) von Ni umfasst.

9. Verfahren nach Anspruch 7 oder 8, wobei die Abscheidung von Ni weiter elektrochemische Plattierung, ECP, (502) von Ni umfasst.

10. Verfahren nach Anspruch 7-9, weiter elektrochemische Plattierung, ECP, (408, 506) einer Goldschicht auf den elektrisch leitenden Boden (110), der Nickelsilizid (112) umfasst, umfassend.

11. Verfahren nach Anspruch 7 oder 8, weiter die Durchführung einer stromlosen Abscheidung (Schritt 308) von Pd (118) auf den elektrisch leitenden Boden (110), der Nickelsilizid (112) umfasst, umfassend.

12. Verfahren nach Anspruch 11, weiter die Durchführung von stromloser oder Tauchabscheidung (310) von Gold (116) auf den elektrisch leitenden Boden (110), der Nickelsilizid (112) und abgeschiedenes Pd (118) umfasst, umfassend.

## Revendications

1. Électrode maître (100) pour la formation d'une pile électrochimique comprenant un substrat, ladite électrode maître comprenant un premier côté (102) pour son arrangement sur le substrat et un second côté (104) pour sa connexion à une alimentation électrique, ladite électrode maître comprenant en outre :
au moins une cavité (106) sur le premier côté (102) pour la formation de ladite pile électrochimique, ladite cavité (106) possédant des parois latérales (108) procurant une isolation électrique et une base électroconductrice (110) comprenant du siliciure (112) ;
une surface électroconductrice (114) sur le second côté (114) pour sa connexion à une alimentation électrique, ladite surface électroconductrice (114) étant reliée par conduction à la base électroconductrice (110) comprenant du siliciure (112) ;
**caractérisée en ce que** le substrat est un substrat à base de silicium et le siliciure est du siliciure de nickel.

2. Électrode maître (100) selon la revendication 1, dans laquelle ladite base électroconductrice (110) comprend au moins une couche d'or (116) ; dans laquelle du siliciure de nickel (112) est disposé en dessous de ladite au moins une couche d'or (116).

3. Électrode maître (100) selon l'une quelconque des revendications 2, dans laquelle la base électroconductrice (110) comprend en outre une couche adhésive (118) entre la base électroconductrice comprenant du siliciure de nickel (112) et ladite au moins une couche d'or (116) ; dans laquelle ladite couche adhésive (118) comprend du Pd.

4. Électrode maître (100) selon l'une quelconque des revendications 1 à 3, dans laquelle la surface électroconductrice (114) sur le second côté (104) comprend une matière (114) à base de Ni.

5. Électrode maître (100) selon l'une quelconque des revendications 1 à 4, dans laquelle le siliciure de nickel est un siliciure de nickel répondant à la formule générale NixSiy, dans laquelle x peut varier de 1 à 31 et y de 1 à 12.

6. Électrode maître (100) selon la revendication 5, dans laquelle x est supérieur à y.

7. Procédé pour la formation d'une électrode maître (100) pour la définition d'une pile électrochimique comprenant un substrat à base de silicium ; dans lequel l'électrode maître possède au moins une cavité (106) sur un premier côté (102), dans lequel la cavité forme une pile électrochimique, le procédé comprenant le fait de :
obtenir une base électroconductrice comprenant du Ni (202, 302, 402, 502) de ladite au moins une cavité (106) sur le premier côté de l'électrode maître, en mettant en oeuvre un dépôt de Ni sur le substrat à base de silicium ; et
soumettre à un recuit (304, 406, 504) la base électroconductrice comprenant du Ni, pour obtenir une base électroconductrice comprenant du siliciure de nickel (112).

8. Procédé selon la revendication 7, dans lequel le dépôt de Ni comprend un dépôt physique en phase vapeur, PVD (302, 402), de Ni.

9. Procédé selon la revendication 7 ou 8, dans lequel le dépôt de Ni comprend en outre un placage électrochimique, ECP (502), de Ni.

10. Procédé selon les revendications 7 à 9, comprenant en outre un placage électrochimique, ECP (408, 506), d'or sur la base électroconductrice (110) comprenant du siliciure de nickel (112).

11. Procédé selon la revendication 7 ou 8, comprenant en outre la mise en oeuvre d'un dépôt autocatalytique (étape 308) de Pd (118) sur la base électroconductrice (110) comprenant du siliciure de nickel (112).

12. Procédé selon la revendication 11, comprenant la mise en oeuvre d'un dépôt autocatalytique ou par immersion (310) d'or (116) sur la base électroconductrice (110) comprenant du siliciure de nickel (112) et du Pd déposé (118).
